# EUROPÄISCHE PATENTSCHRIFT

(11) **EP 0 888 642 B1**
(45) Veröffentlichungstag und Bekanntmachung des Hinweises auf die Patenterteilung: **18.12.2013**
(21) Anmeldenummer: 97918043.7
(22) Anmeldetag: 20.03.1997
(51) Int. Cl.: H01L 23/00, H01S 5/40, H01S 5/022

(54) **HALBLEITERVORRICHTUNG**
SEMICONDUCTOR DEVICE
DISPOSITIF A SEMICONDUCTEUR

(30) Priorität: 20.03.1996 DE 19611046
(43) Veröffentlichungstag der Anmeldung: 07.01.1999
(73) Patentinhaber: OSRAM Opto Semiconductors GmbH, 93055 Regensburg (DE)
(72) Erfinder: GRÖTSCH, Stefan, D-93053 Regensburg (DE); ALTHAUS, Hans-Ludwig, D-93138 Lappersdorf (DE)
(74) Vertreter: Epping - Hermann - Fischer
(86) Internationale Anmeldenummer: PCT/DE1997/000574
(87) Internationale Veröffentlichungsnummer: WO 1997/035347

(56) Entgegenhaltungen:
- EP-A- 0 766 355
- DE-A- 4 315 580
- GB-A- 2 062 346
- PATENT ABSTRACTS OF JAPAN vol. 007, no. 140 (E-182), 18.Juni 1983 & JP 58 052892 A (HITACHI SEISAKUSHO KK), 29.März 1983,
- PATENT ABSTRACTS OF JAPAN vol. 012, no. 049 (E-582), 13.Februar 1988 & JP 62 198140 A (MITSUBISHI ELECTRIC CORP), 1.September 1987,
- PATENT ABSTRACTS OF JAPAN vol. 017, no. 514 (E-1433), 16.September 1993 & JP 05 136183 A (MITSUBISHI ELECTRIC CORP), 1.Juni 1993,
- PATENT ABSTRACTS OF JAPAN vol. 006, no. 176 (E-130), 10.September 1982 & JP 57 092842 A (MITSUBISHI ELECTRIC CORP), 9.Juni 1982,
- DATABASE WPI Section Ch, Week 8007 Derwent Publications Ltd., London, GB; Class L03, AN 80-12168c XP002035141 & JP 49 044 672 A (SANKEN DENKI KK) , 26.April 1974

## Beschreibung

Die Erfindung bezieht sich auf eine Halbleitervorrichtung. Insbesondere handelt es sich hierbei um ein Leistungs-Halbleiterbauelement, wie beispielsweise ein Leistungs-Laserdioden-Barren oder ein Leistungs-Transistor, der auf einem Kühlkörper (Wärmesenke) befestigt ist.

Eine solche Halbleitervorrichtung ist beispielsweise aus der deutschen Offenlegungsschrift DE 4 315 580 bekannt. Hierin ist eine Anordnung aus Laserdioden und einem Kühlsystem beschrieben, bei der ein Laserdioden-Barren auf einer Mikrokanalwärmesenke (MKWS), bestehend aus Kupferblechen, aufgelötet ist. Zur Reduzierung von Verspannungen aufgrund unterschiedlicher thermischer Ausdehnungen des Laserdioden-Barrens (z. B. bestehend aus einer Anordnung von GaAs und AlₓGa₁₋ₓAs-Schichten) und der MKWS werden als Verbindungsmittel sogenannte Weichlote wie beispielsweise In, InSn oder PbSn verwendet. Weichlote weisen eine sehr gute plastische Verformbarkeit auf und kompensieren mechanische Spannungen im plastischen Dehnungsbereich.

Ein Nachteil der oben beschriebenen Anordnung besteht darin, daß die Lötverbindung zwischen Laserdioden-Barren und MKWS nur sehr niedrige Temperaturbeständigkeit und geringe Temperaturzykelbeständigkeit bis zum teilweisen oder vollständigen Bruch der Verbindung aufgrund häufiger Belastung im plastischen Dehnungsbereich aufweist. Ein teilweises oder vollständiges Abreißen des Laserdioden-Barrens von der MKWS führt aber zu einer Verschlechterung der Wärmeableitung vom sowie zu einer inhomogenen Stromverteilung im Laserdioden-Barren und kann im Extremfall dessen Zerstörung bewirken.

Derartige Probleme beschränken sich verständlicherweise nicht ausschließlich auf Laserdioden, sondern treten überall dort auf, wo ein Halbleiterbauelement, das auf ein Trägerteil montiert ist, dessen thermischer Ausdehnungskoeffizient von dem des Halbleiterbauelements stark abweicht, im Betrieb größeren Temperaturschwankungen ausgesetzt ist.

Aus der JP-A-57-092842 ist ein Verfahren zum Herstellen eines Halbleiter-Elements bekannt, bei dem zwischen einem Si-Wafer und einer Trägerplatte, die mit einer Mo-Schicht versehen ist, eine aus einer eutektischen Al-Si-Legierung bestehende Schicht ausgebildet wird. Dieses Verfahren eignet sich ausschließlich für die Montage von Si-Wafern und beispielsweise nicht für Halbleiter-Laserchips. Letztere bestehen bekanntlich aus III-V- oder II-VI-Verbindungshalbleiter-Materialien.

In der JP-A-58-052892 ist eine Montagestruktur für ein Halbleiterlaser-Element beschrieben, bei der zwischen einem Halbleiter-Laserchip und einem Trägerteil aus Kupfer ein Submount, bestehend aus Molybdän, angeordnet ist. Das Molybdän-Submount hat einen thermischen Ausdehnungskoeffizienten, der ähnlich dem des Halbleiter-Laserchips ist. Der Halbleiter-Laserchip ist mit einer ersten Lotschicht, die ein Hartlotmaterial enthält, mit dem Submount und mittels einer weiteren Lotschicht, die ein Weichlotmaterial enthält, mit dem Trägerteil verbunden.

Die Druckschrift JP-A-49-044672 offenbart ein Halbleiterbauelement, bei dem eine Zwischenelektrode aus W oder Mo mit einem Pb-Lot mit dem Halbleiterchip und mit einem Au-Ag-Lot mit einer weiteren Elektrode verbunden ist.

Die Druckschrift JP-A-05-136183 offenbart eine Halbleitervorrichtung, bei der ein Leistungsbauelement mit einer Lotschicht, die 95% Pb enthält, mit einem Cu-Leadframe verbunden ist, wobei zwischen dem Leistungsbauelement und dem Leadframe eine Molybdänschicht angeordnet ist.

Die Druckschrift JP-A-62-198140 offenbart eine Halbleitervorrichtung, bei der ein Halbleiterchip mit einer Hartlotschicht auf einer Molybdänschicht befestigt ist. Die Molybdänschicht ist mit einer weiteren Lotschicht, die in einem Metallgitter aufgebracht ist, mit einer Wärmesenke verbunden.

Der vorliegenden Erfindung liegt die Aufgabe zugrunde, eine Halbleitervorrichtung, insbesondere eine HalbleiterLaservorrichtung zu entwickeln, bei der die Verbindung zwischen dem Halbleiterbauelement und dem Trägerteil eine verbesserte Temperaturbeständigkeit und eine hohe Temperaturzykelstabilität aufweist.

Diese Aufgabe wird durch eine Halbleitervorrichtung mit den Merkmalen des Anspruches 1 gelöst. Bevorzugte Ausführungsformen der Erfindung sind in den Unteransprüchen 2 bis 12 angegeben.

Erfindungsgemäß ist vorgesehen, daß zwischen dem Halbleiterbauelement und dem Trägerteil eine Spannungskompensationsschicht vorgesehen ist. Diese besteht aus einem Material, dessen thermischer Ausdehnungskoeffizient ähnlich dem des Materials des Halbleiterbauelements ist und das einen derart hohen Elastizitätsmodul aufweist, daß die Spannungskompensationsschicht mechanische Spannungen zwischen dem Halbleiterbauelement und dem Trägerteil aufgrund von unterschiedlichen thermischen Ausdehnungen im elastischen Dehnungsbereich kompensiert. Die Spannungskompensationsschicht ist mittels einer ersten Hartlotschicht mit dem Halbleiterbauelement und mittels einer zweiten Hartlotschicht mit dem Trägerteil verbunden.

Die Spannungskompensationsschicht erstreckt sich bevorzugt im wesentlichen über den gesamten Verbindungsbereich zwischen Halbleiterbauelement und Trägerteil, wodurch eine maximale Spannungskompensation gewährleistet ist. Bei einer besonders bevorzugten Ausführungsform grenzt die erste Hartlotschicht einerseits unmittelbar an das Halbleiterbauelement und andererseits unmittelbar an die Spannungskompensationsschicht. Analog dazu grenzt die zweite Hartlotschicht einerseits unmittelbar an die Spannungskompensationsschicht und andererseits unmittelbar an das Trägerteil.

Die erfindungsgemäße Halbleitervorrichtung hat den Vorteil, daß mechanische Verspannungen, verursacht durch unterschiedliche thermische Ausdehnungen von Trägerteil und Halbleiterbauelement nicht mehr, wie aus dem Stand der Technik bekannt, mittels eines plastisch verformbaren Weichlotmaterials kompensiert werden, sondern größtenteils von der Spannungskompensationsschicht im elastischen Dehnungsbereich aufgenommen werden. Die mechanischen Spannungen werden daher aufgrund der Verwendung von sehr stabilen und im Vergleich zu Weichlotschichten sehr starren Hartlotschichten nicht in das Innere des Halbleiterbauelements übertragen. Mechanische Spannungen im Halbleiterbauelement, insbesondere bei einem Halbleiterlaser-Bauelement, würden zu einer Beeinträchtigung der Funktion des Halbleiterbauelements führen. Daher ist es durch die Erfindung möglich, Verbindungen zwischen Halbleiterbauelement und Trägerteil herzustellen, die hochtemperaturfest (>250°C) und extrem zykelstabil sind. Als Hartlotmaterialien für die Verbindungsschichten eignen sich beispielsweise AuSn, AuGe oder AuSi.

Hartlotverbindungen besitzen im allgemeinen eine wesentlich höhere mechanische und thermische Stabilität als die bekannten Verbindungen aus verformbaren Lotmaterialien. An Stelle derartiger Hartlotmaterialien können selbstverständlicherweise auch andere Verbindungsmaterialien, welche die oben erwähnten Eigenschaften aufweisen, verwendet sein. Der Begriff "Hartlot" schließt im Zusammenhang mit der vorliegenden Erfindung auch diese Materialien mit ein.

Bei einer bevorzugten Ausgestaltung der erfindungsgemäßen Halbleitervorrichtung ist die Spannungskompensationsschicht eine Folie, z. B. ein Molybdän-Leadframe (Anschlußrahmen). Eine Folie kann vorteilhafterweise separat, d. h. vom Halbleiterbauelement entkoppelt hergestellt und mechanisch sehr stabil ausgebildet sein. Bei der Fertigung einer derartigen Spannungskompensationsschicht ist es nämlich nicht mehr erforderlich, auf Prozeßschritte, die zu einer Schädigung des Halbleiterbauelements führen würden (z. B. Hochtemperaturbehandlungen), zu verzichten.

Besonders vorteilhaft für die Fertigung einer Mehrzahl von erfindungsgemäßen Halbleitervorrichtungen ist es, wenn die Halbleiterbauelemente auf Leiterbänder montiert werden, die aus dem Material der Spannungskompensationsschicht bestehen. Die Halbleiterbauelemente können dann auf einfache Weise mit Hilfe von herkömmlichen Montagelinien kostengünstig weiterverarbeitet werden. Diese Ausführungsform hat den weiteren Vorteil, daß die Spannungskompensationsschicht mit einer Anschlußfahne ausgebildet und somit gleichzeitig als elektrischer Anschluß zur Stromzuführung für das Halbleiterbauelement verwendet werden kann.

Für die Spannungskompensationsschicht eignen sich sämtliche Materialien mit einem hohen Elastizitätsmodul, hoher Fließspannung und hoher Temperaturbeständigkeit. Als bevorzugtes Spannungskompensationsschichtmaterial für Halbleiterbauelemente aus GaAs und/oder AlGaAs wäre beispielsweise Molybdän anzuführen. Ebenso besitzen z. B. auch Wolfram, CuW-Legierungen und CuMo-Legierungen (Cu-Anteil jeweils zwischen 10 und 20%) die oben genannten erforderlichen Eigenschaften für Spannungskompensationsschichtmaterialien. Alle diese Materialien lassen sich sowohl als Folie als auch als Sputter-, Aufdampf- oder Galvanikschicht herstellen und weisen vorteilhafterweise eine gute Wärmeleitfähigkeit auf.

Besonders positiv wirkt sich die Erfindung bei Leistungs-Halbleiterbauelementen wie z. B. Leistungs-Laserdioden oder Leistungs-Transistoren aus, die auf Kühlkörper montiert sind. Während sich die oben genannten Halbleiterbauelemente bekannterweise betriebsbedingt stark erhitzen, erfahren die Kühlkörper bestimmungsgemäß nur eine geringfügige Erwärmung. Unterschiedliche thermische Ausdehnungen sind aufgrunddessen bei diesen Bauteilen unvermeidbar. Die dadurch hervorgerufenen mechanischen Verspannungen zwischen Halbleiterbauelement und Trägerteil werden erfindungsgemäß weitestgehend von der Spannungskompensationsschicht aufgenommen. Eine mechanische Belastung des Halbleiterbauelements tritt daher, wenn überhaupt, nur in geringfügigem Maße auf.

Vorteilhaft wirkt sich die Erfindung jedoch auch bei Halbleitervorrichtungen aus, die großen Schwankungen der Umgebungstemperatur ausgesetzt sind, wie dies beispielsweise in Automobilen, Flugzeugen, Öfen usw. der Fall ist, und bei denen ein Halbleiterbauelement auf einem Trägerteil befestigt ist, dessen thermischer Ausdehnungskoeffizient von der des Halbleiterbauelements deutlich verschieden ist. Als Beispiele seien hier Si- oder III-V-Halbleiterbauelemente auf Cu-Leadframes genannt.

Bei einer besonders bevorzugten Ausführungsform der erfindungsgemäßen Halbleitervorrichtung weist das Halbleiterbauelement AlₓGa₁₋ₓAs (0 ≤ x ≤ 1) auf und/oder besteht das Trägerteil im wesentlichen aus einem metallischen Werkstoff, aus Halbleitermaterial mit guter Wärmeleitfähigkeit oder aus Diamant.

Weitere Vorteile, Merkmale und Zweckmäßigkeiten der Erfindung ergeben sich aus der folgenden Beschreibung von erfindungsgemäßen Ausführungsbeispielen und Vergleichsbeispielen in Verbindung mit den Figuren 1 bis 5.

Es zeigen:
- Figur 1: eine schematische Schnittdarstellung eines ersten Ausführungsbeispieles einer erfindungsgemäßen Halbleitervorrichtung,
- Figur 2: eine schematische Darstellung einer Draufsicht auf ein zweites Ausführungsbeispiel einer erfindungsgemäßen Halbleitervorrichtung,
- Figur 3: eine schematische Schnittdarstellung eines Vergleichsbeispieles einer Halbleitervorrichtung,
- Figur 4: eine schematische Schnittdarstellung eines weiteren Vergleichsbeispieles einer Halbleitervorrichtung,
- Figur 5: eine schematische Darstellung einer Draufsicht auf eine besondere Ausführungsform der in Fig. 3 gezeigten Halbleitervorrichtung.

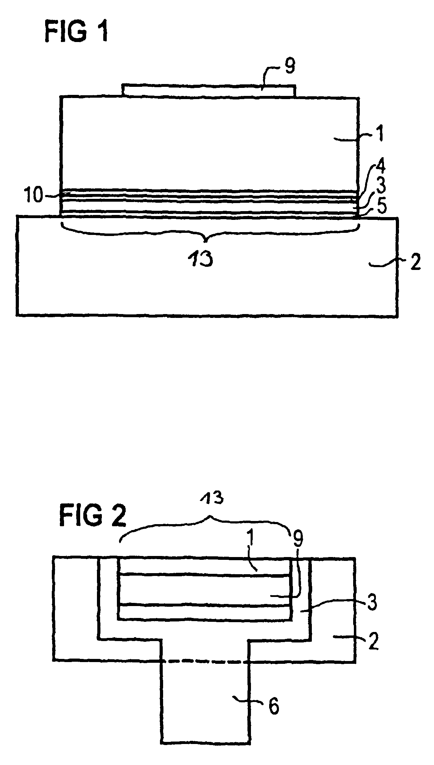

Bei einem in Figur 1 dargestellten ersten Ausführungsbeispiel ist ein Halbleiterbauelement 1 auf einem Trägerteil 2 befestigt. Das Halbleiterbauelement 1 ist beispielsweise eine Leistungs-Laserdiode, ein Leistungs-Laserdiodenbarren, ein Leistungs-Transistor oder ein anderes Halbleiterbauelement mit den für einen bestimmungsgemäßen Betrieb erforderlichen elektrischen Anschlüssen 9,10. Das Trägerteil 2 ist beispielsweise ein herkömmlicher Kühlkörper, der z. B. aus Cu, Si, Diamant oder aus einem anderen gut wärmeleitenden Material besteht, oder eine elektrische Anschlußplatte, die wiederum aus Kupfer oder aus einem anderen gut elektrisch leitenden Werkstoff bestehen kann. Selbstverständlich kann ein Kühlkörper, vorausgesetzt dieser ist elektrisch leitend, gleichzeitig als elektrischer Anschluß für das Halbleiterbauelement genutzt sein.

Zwischen dem Halbleiterbauelement 1 und dem Trägerteil 2 befindet sich eine Spannungskompensationsschicht 3, beispielsweise eine Molybdänfolie (Dicke z. B. zwischen 20 und 300 µm) oder eine Folie aus einem anderen Material mit den weiter oben genannten Eigenschaften, insbesondere mit einem hohen Elastizitätsmodul und einem thermischen Ausdehnungskoeffizienten, der dem des Materials des Halbleiterbauelements 1 ähnlich ist. Diese Spannungskompensationsschicht 3 ist mittels Verbindungsschichten 4, 5 einerseits mit dem Halbleiterbauelement 1 und andererseits mit dem Trägerteil 2 starr verbunden und erstreckt sich über den gesamten Verbindungsbereich 13 zwischen Halbleiterbauelement 1 und Trägerteil 2. Als Material für die Verbindungsschichten 4, 5 eignet sich ein Hartlotmaterial, wie z. B. AuSn, AuGe oder AuSi.

Bei einem zweiten Ausführungsbeispiel, von dem in Figur 2 eine schematische Draufsicht dargestellt ist, weist die Spannungskompensationsschicht 2 eine Anschlußfahne 6 auf. Die Spannungskompensationsschicht 2 dient in diesem Ausführungsbeispiel gleichzeitig als elektrischer Anschluß (Leadframe) für das Halbleiterbauelement. Hinsichtlich Material der Spannungskompensationsschicht 3 und hinsichtlich Verbindungsschichten 4, 5 ist dieses Ausführungsbeispiel entsprechend dem oben beschriebenen Ausführungsbeispiel von Figur 1 ausgeführt.

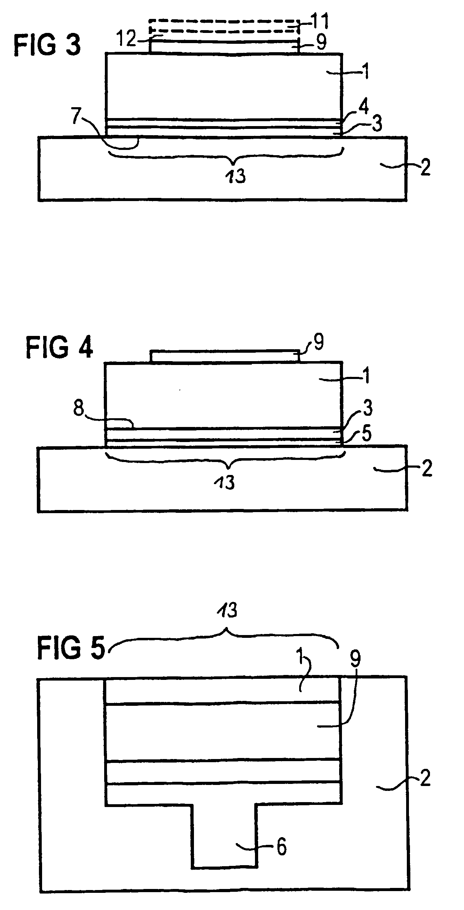

Das Vergleichsbeispiel von Figur 3 weist gegenüber den beiden vorgenannten Ausführungsbeispielen den Unterschied auf, daß hier, wie in Figur 3 deutlich dargestellt, nur zwischen Halbleiterbauelement 1 und Spannungskompensationsschicht 3 eine Verbindungsschicht 4 angeordnet ist. Die Verbindungsschicht 4 besteht wiederum aus einem Hartlotmaterial und die Spannungskompensationsschicht 3 ist direkt auf eine Hauptfläche 7 des Trägerteiles 2 aufgebracht. Als Herstellungsverfahren für eine derartige Spannungskompensationsschicht 3 eignen sich beispielsweise Sputtern, Aufdampfen, Galvanik oder eine andere dem Fachmann als geeignet bekannte Methode. Denkbar ist aber auch, daß eine vorgefertigte Spannungskompensationsschicht 3 mittels Diffusionsschweißen oder anodischem Bonden auf dem Trägerteil 2 befestigt ist, falls für die Spannungskompensationsschicht 3 und das Trägerteil 2 geeignete Materialien für ein derartiges Verfahren verwendet sind.

Wie in Figur 5 gezeigt, kann die Spannungskompensationsschicht 3 auch dann mit einer Anschlußfahne 6 versehen sein, wenn sie, wie beim Ausführungsbeispiel von Figur 3, auf dem Trägerteil 2 aufgebracht ist. Die Spannungskompensationsschicht 3 mit Anschlußfahne 6 kann beispielsweise mittels strukturierter Aufbringung (Sputtern, Aufdampfen o. ä.) des Spannungskompensationsschichtmaterials auf das Trägerteil 2 hergestellt sein.

Bei dem in Figur 4 schematisch dargestellten weiteren Vergleichsbeispiel ist die Spannungskompensationsschicht 3 auf eine Hauptfläche 8 des Halbleiterbauelements 1 aufgebracht. Zwischen dem Trägerteil 2 und der Spannungskompensationsschicht 3 befindet sich eine Verbindungsschicht 5, die wiederum bevorzugt aus einem Hartlotmaterial besteht. Die Spannungskompensationsschicht kann wiederum mittels Sputtern, Aufdampfen o. ä. auf die Unterseite des Halbleiterbauelements 1 aufgebracht sein.

Abschließend ist noch anzuführen, daß, wie in Figur 3 durch gestrichelte Linien angedeutet, bei einer weiteren vorteilhaften Ausführungsform der Halbleitervorrichtung der elektrische Anschluß 9 an der Oberseite des Halbleiterbauelements 1 über eine Verbindungsschicht 12 mit einer Anschlußschicht 11 verbunden ist, die aus demselben Material besteht wie die Spannungskompensationsschicht 3. Dadurch können mechanische Spannungen im Halbleiterbauelement 1 aufgrund unterschiedlicher thermischer Ausdehnungen von Halbleiterbauelement 1 und Trägerteil 2 weiter reduziert werden. Diese Weiterbildung der Erfindung kann selbstverständlicherweise bei jedem der oben beschriebenen Ausführungsbeispiele vorgesehen sein.

## Patentansprüche

1. Halbleitervorrichtung, bei der ein Halbleiterbauelement auf einem Trägerteil befestigt ist und zwischen dem Halbleiterbauelement (1) und dem Trägerteil (2) eine Spannungskompensationsschicht (3) vorgesehen ist, die aus einem Material besteht, dessen thermischer Ausdehnungskoeffizient an den des Materials des Halbleiterbauelements (1) angepaßt ist,
wobei
die Spannungskompensationsschicht (3) einen derart hohen Elastizitätsmodul aufweist, daß sie mechanische Spannungen zwischen dem Halbleiterbauelement (1) und dem Trägerteil (2) im elastischen Dehnungsbereich kompensiert, und
die Spannungskompensationsschicht (3) mittels einer ersten Hartlotschicht (5) mit dem Trägerteil (2) und mittels einer zweiten Hartlotschicht (4) mit dem Halbleiterbauelement (1) verbunden ist.

2. Halbleitervorrichtung nach Anspruch 1,
**dadurch gekennzeichnet, daß**
das Halbleiterbauelement AlₓGa₁₋ₓAs (0 ≤ x ≤ 1) aufweist.

3. Halbleitervorrichtung nach Anspruch 1 oder 2,
**dadurch gekennzeichnet, daß**
die Spannungskompensationsschicht (3) eine Folie ist.

4. Halbleitervorrichtung nach Anspruch 3,
**dadurch gekennzeichnet, daß**
die Folie als Anschlußrahmen ausgebildet ist.

5. Halbleitervorrichtung nach einem der Ansprüche 1 bis 4,
**dadurch gekennzeichnet , daß** die Spannungskompensationsschicht (3) im wesentlichen aus Molybdän besteht.

6. Halbleitervorrichtung nach Anspruch 5,
**dadurch gekennzeichnet, daß**
die Spannungskompensationsschicht (3) eine Dicke zwischen 20 µm und 300 µm aufweist.

7. Halbleitervorrichtung nach einem der Ansprüche 1 bis 4,
**dadurch gekennzeichnet, daß**
die Spannungskompensationsschicht (3) im wesentlichen aus Wolfram, einer CuW-Legierung oder einer CuMo-Legierung besteht,
wobei der Cu-Anteil zwischen 10% und 20% beträgt.

8. Halbleitervorrichtung nach einem der Ansprüche 1 bis 7,
**dadurch gekennzeichnet, daß**
sich die Spannungskompensationsschicht (3) über den gesamten Verbindungsbereich (13) zwischen dem Halbleiterbauelement (1) und dem Trägerteil (2) erstreckt.

9. Halbleitervorrichtung nach einem der Ansprüche 1 bis 8,
**dadurch gekennzeichnet, daß**
die Spannungskompensationsschicht (3) eine Anschlußfahne (6) aufweist.

10. Halbleitervorrichtung nach einem der Ansprüche 1 bis 9,
**dadurch gekennzeichnet, daß**
das Halbleiterbauelement (1) ein Leistungs-Halbleiterbauelement und das Trägerteil (2) eine Wärmesenke ist.

11. Halbleitervorrichtung nach einem der Ansprüche 1 bis 10,
**dadurch gekennzeichnet, daß**
die Halbleitervorrichtung eine Halbleiterlaservorrichtung ist.

12. Halbleitervorrichtung nach Anspruch 11,
**dadurch gekennzeichnet, daß**
das Halbleiterbauelement (1) ein Leistungs-Halbleiterlaser-Barren ist.

## Claims

1. Semiconductor device, in which a semiconductor component is fixed on a carrier part and a stress compensation layer (3) is provided between the semiconductor component (1) and the carrier part (2), the said stress compensation layer consisting of a material whose coefficient of thermal expansion is adapted to that of the material of the semiconductor component (1),
wherein
the stress compensation layer (3) has such a high modulus of elasticity that it compensates for mechanical stresses between the semiconductor component (1) and the carrier part (2) in the elastic expansion range, and
the stress compensation layer (3) is connected to the carrier part (2) by means of a first hard solder layer (5) and to the semiconductor component (1) by means of a second hard solder layer (4).

2. Semiconductor device according to Claim 1,
**characterized in that**
the semiconductor component comprises AlₓGa₁₋ₓAs (0 ≤ x ≤ 1).

3. Semiconductor device according to Claim 1 or 2,
**characterized in that**
the stress compensation layer (3) is a foil.

4. Semiconductor device according to Claim 3,
**characterized in that**
the foil is formed as a leadframe.

5. Semiconductor device according to one of Claims 1 to 4,
**characterized in that**
the stress compensation layer (3) essentially consists of molybdenum.

6. Semiconductor device according to Claim 5,
**characterized in that**
the stress compensation layer (3) has a thickness of between 20 µm and 300 µm.

7. Semiconductor device according to one of Claims 1 to 4,
**characterized in that**
the stress compensation layer (3) essentially consists of tungsten, a CuW alloy or a CuMo alloy, wherein the proportion of Cu is between 10% and 20%.

8. Semiconductor device according to one of Claims 1 to 7,
**characterized in that**
the stress compensation layer (3) extends over the entire connecting region (13) between the semiconductor component (1) and the carrier part (2).

9. Semiconductor device according to one of Claims 1 to 8,
**characterized in that**
the stress compensation layer (3) has a connection lug (6).

10. Semiconductor device according to one of Claims 1 to 9,
**characterized in that**
the semiconductor component (1) is a power semiconductor component and the carrier part (2) is a heat sink.

11. Semiconductor device according to one of Claims 1 to 10,
**characterized in that**
the semiconductor device is a semiconductor laser device.

12. Semiconductor device according to Claim 11,
**characterized in that**
the semiconductor component (1) is a power semiconductor laser bar.

## Revendications

1. Dispositif à semiconducteur, dans lequel un composant à semiconducteur est fixé sur une partie support et il est prévu entre le composant (1) à semiconducteur et la partie (2) support, une couche (3) de compensation des contraintes, qui est en un matériau dont le coefficient de dilatation thermique est adapté à celui du matériau du composant (1) à semiconducteur,
dans lequel
la couche (3) de compensation des contraintes a un module d'élasticité si grand qu'il compense dans le domaine de l'allongement élastique des contraintes mécaniques entre le composant (1) à semiconducteur et la partie (2) support, et
la couche (3) de compensation des contraintes est reliée au moyen d'une première couche (5) de brasure dure à la partie (2) support et au moyen d'une deuxième couche (4) de brasure dure au composant (1) à semiconducteur.

2. Dispositif à semiconducteur suivant la revendication 1,
**caractérisé en ce que**
le composant à semiconducteur comporte du AlₓGa₁₋ₓAs (0 ≤ x ≤ 1).

3. Dispositif à semiconducteur suivant la revendication 1 ou 2,
**caractérisé en ce que**
la couche (3) de compensation des contraintes est une feuille.

4. Dispositif à semiconducteur suivant la revendication 3,
**caractérisé en ce que**
la feuille est constituée en cadre de connexion.

5. Dispositif à semiconducteur suivant l'une des revendications 1 à 4,
**caractérisé en ce que**
la couche (3) de compensation des contraintes est essentiellement en molybdène.

6. Dispositif à semiconducteur suivant la revendication 5,
**caractérisé en ce que**
la couche (3) de compensation des contraintes a une épaisseur comprise entre 20 µm et 300 µm.

7. Dispositif à semiconducteur suivant l'une des revendications 1 à 4,
**caractérisé en ce que**
la couche (3) de compensation des contraintes est essentiellement en tungstène ou en un alliage de CuW ou de CuMo, dans lequel la proportion du Cu est entre 10 % et 20 %.

8. Dispositif à semiconducteur suivant l'une des revendications 1 à 7,
**caractérisé en ce que**
la couche (3) de compensation des contraintes s'étend sur toute la zone (13) de liaison entre le composant (1) à semiconducteur et la partie (2) support.

9. Dispositif à semiconducteur suivant l'une des revendications 1 à 8,
**caractérisé en ce que**
la couche (3) de compensation des contraintes comporte une oreille (6) de connexion.

10. Dispositif à semiconducteur suivant l'une des revendications 1 à 9,
**caractérisé en ce que**
le composant (1) à semiconducteur est un composant à semiconducteur de puissance et la partie (2) support est un puits de chaleur.

11. Dispositif à semiconducteur suivant l'une des revendications 1 à 10,
**caractérisé en ce que**
le dispositif à semicionducteur est un dispositif laser à semiconducteur.

12. Dispositif à semiconducteur suivant la revendication 11,
**caractérisé en ce que**
le composant (1) à semiconducteur est un barreau laser à semiconducteur de puissance.
